Europäisches Patentamt

European Patent Office

Office européen des brevets

(19)

(11) Publication number: **0 241 187**
**B1**

## EUROPEAN PATENT SPECIFICATION

(12)

(45) Date of publication of the patent specification:
07.11.90

(51) Int. Cl.⁵: **C30B 7/10, C30B 29/22**

(21) Application number: 87302673.6

(22) Date of filing: 27.03.87

(54) A method of manufacturing a single crystal of BaPb1-xBix03.

(30) Priority: 03.04.86 JP 77347/86

(43) Date of publication of application:
14.10.87 Bulletin 87/42

(45) Publication of the grant of the patent:
07.11.90 Bulletin 90/45

(84) Designated Contracting States:
DE FR GB

(56) References cited:
EP-A- 0 199 440

(73) Proprietor: SEIKO INSTRUMENTS INC., 31-1,
Kameido 6-chome Koto-ku, Tokyo 136(JP)
Proprietor: Hirano, Shinichi, 123 Medai Yadacho
Syukusha 66, Yadacho 2-chome, Higashi-ku Nagayo-shi
Aichi(JP)

(72) Inventor: Hirano, Shinichi c/o 123 Meidai Yadacho
Syukusha, 66, Yadacho 2-chome, Higashi-ku,
Nagayo-shi, Aichi(JP)
Inventor: Toyokuni, Ryo c/o Seiko Instruments Inc.,,
31-1, Kameido 6-chome, Koto-ku, Tokyo(JP)
Inventor: Kuroda, Hiroshi c/o Seiko Instruments Inc.,
31-1, Kameido 6-chome, Koto-ku, Tokyo(JP)

(74) Representative: Caro, William Egerton et al, J. MILLER &
CO. Lincoln House 296-302 High Holborn, London
WC1V 7JH(GB)

**Description**

This invention relates to methods of manufacturing single crystals of $BaPb_{1-x}Bi_xO_3$. Such single crystals are useful as super-conducting elements, semiconducting elements or optoelectronic elements widely used in the electronics industry, etc.

$BaPb_{1-x}Bi_xO_3$ (barium-lead-bismuth oxide) where $x$ is the so-called "composition factor" with a Perovskite structure, shows super-conductivity in the range of $0.05 \leq x \leq 0.30$, semi-metallic characteristics in the range of $x < 0.05$, and semiconductivity in the range of $0.30 < x$. The super-conductive transition temperature Tc is a maximum (13°K) when $x$ is approximately 0.25. This is the highest known temperature at which an oxide material that does not include transition metal elements exhibits super-conductivity. Attention has focussed on these barium-lead-bismuth oxide compounds because of their super-conductivity and because the super-conductivity depends on their exact composition. Further, the compounds of this type include semi-metallic materials and their carrier density N(O) at the Fermi surface is extraordinarily small as a super-conductor. Therefore, these compounds have a resistance rate which is several orders of magnitude greater than ordinary metal super-conductors, at temperatures slightly higher than Tc. This characteristic is required for materials used for super-conductive switches. When barium-lead-bismuth oxide compounds are formed as single crystals they are relatively stable and crystals which are transparent in the infra-red region, can be expected to be useful for optical electronic elements at very low temperatures.

Conventionally, growing a single crystal of $BaPb_{1-x}Bi_xO_3$ is carried out by crystallisation utilising a flux. In one method, potassium chloride (KCl) is used as the main component of the flux. KCl flux is favoured as the flux to dissolve $BaPb_{1-x}Bi_xO_3$, but to dissolve KCl and to melt KCl in $BaPb_{1-x}Bi_xO_3$, a high temperature of about 1000°C is necessary, and thus potassium ions remain inside the single crystals of $BaPb_{1-x}Bi_xO_3$. Consequently, the impurity density is relatively large. Also, as the crystal grows at a temperature higher than the transition point (500°C to 600°C) of $BaPb_{1-x}Bi_xO_3$, a crystal phase transition occurs on cooling and, therefore, strains occur within the crystal. Another method uses a $PbO_2$-$Bi_2O_3$-$BaPbO_3$ non-stoichiometric solution. In this case, there is an advantage that the inclusion of impurities will be greatly reduced, but, when crystallising $BaPb_{1-x}Bi_xO_3$ from a non-stoichiometric solution, control of the composition factor $x$, that determines the characteristics of the resulting crystal, is very difficult. Also, strains accompanying the phase transition occur as stated above.

The above prior methods are disclosed in Akinori Katsui; Japanese Journal of Applied Physics, Vol. 21 No. 9., (1982) Page 553 to 554.

With the conventional method of manufacturing single crystals of $BaPb_{1-x}Bi_xO_3$ the impurity density within the material is relatively large, and also, the change of the composition factor $x$ is relatively wide. Also the conventional methods have serious disadvantages, such as the reproducibility of the composition factor $x$ is poor, and as a result of the phase transition heat strains remain because high temperatures of about 1000°C are used. These disadvantages are the primary factors that prevent sharp transition to super-conductivity of the resulting single crystal.

EP-A 0 199 440 discloses a method of manufacturing a single crystal of $BaPb_{1-x}Bi_xO_3$ by hydrothermal synthesis using a chloride aqueous solution.

It is thought that the above disadvantages of the prior art, e.g. impurities, the change of composition factor $x$ and strains, are caused by crystallising $BaPb_{1-x}Bi_xO_3$ from a solution which has a relatively high viscosity and large composition change, at a very high temperature.

The present invention seeks to provide a method of manufacturing a single crystal of $BaPb_{1-x}Bi_xO_3$ by hydrothermal synthesis, which enable the crystal to grow at a relatively low temperature below 500°C so that it is possible to improve the characteristics of the resultant single crystal avoiding its phase transition.

According to one aspect of the present invention there is provided a method of manufacturing a single crystal of $BaPb_{1-x}Bi_xO_3$ by dissolving $BaPb_{1-x}Bi_xO_3$ in an aqueous solution and subjecting the resulting solution to a hydrothermal process at a temperature above 350°C, characterised in that the aqueous solution comprises a nitrate as the main component.

Said hydrothermal process may be carried out in a pressure vessel and the single crystal of $BaPb_{1-x}Bi_xO_3$ is grown on an upper wall inside the pressure vessel.

According to a further aspect of the present invention there is provided a method of manufacturing a single crystal of $BaPb_{1-x}Bi_xO_3$ comprising: providing a starting material comprised of $BaCO_3$, $PbO_2$ and $Bi_2O_3$ mixed together; preparing a nutrient composed of polycrystalline $BaPb_{1-x}Bi_xO_3$ obtained from the starting material; and subjecting the nutrient in an aqueous solution to a hydrothermal process at a temperature above 350°C to effect growth of the single crystal of $BaPb_{1-x}Bi_xO_3$ characterised in that the aqueous solution includes a nitrate as the main component.

Said hydrothermal process may be carried out in a pressure vessel, a temperature gradient being maintained between upper and lower portions of the pressure vessel.

According to still another aspect of the present invention there is provided a method of manufacturing a single crystal of $BaPb_{1-x}Bi_xO_3$ comprising: providing a nutrient composed of polycrystalline $BaPb_{1-x}Bi_xO_3$; and subjecting the nutrient in an aqueous solution to a hydrothermal process at a temperature above 350°C to establish a temperature gradient within the aqueous solution effective to promote ·the growth of the single crystal of $BaPb_{1-x}Bi_xO_3$ characterised in that the aqueous solution includes a nitrate.

Said nitrate may be any one or more of $LiNO_3$, $KNO_3$ and $NaNO_3$.

The single crystal of $BaPb_{1-x}Bi_xO_3$ may be grown as a thin film on a substrate, for example, of $SrTiO_3$.

Said substrate is preferably maintained about 40°C lower than the nutrient.

The method may include quickly cooling thge single crystal of $BaPb_{1-x}Bi_xO_3$ after the hydrothermal process.

The aqueous solution preferably includes an oxygen-generating compound, for example, any one or more of $KClO_3$, $NaClO_3$ and $NaClO_4$.

The invention is illustrated, merely by way of example, in the accompanying drawings, in which:

Figure 1 is a sectional view of an autoclave used in Example 3 of a method according to the present invention;

Figure 2 is a characteristic diagram showing the variation of cubic imitated lattice constant A corresponding to composition factor X;

Figure 3 ist a sectional diagram showing the structure of an autoclave used in Example 1 of a method according to the present invention; and

Figure 4 is a graph illustrating super-conducting characteristics of a single crystal of $BaPb_{1-x}Bi_xO_3$ obtained by a method according to the present invention and a conventional method.

In hydrothermal synthesis, the starting material is dissolved in a solution of an appropriate solvent at an appropriate temperature and pressure, and the intended crystal is crystallised or grown on a suitable substrate. The growth temperature is generally from 350°C to 600°C and this temperature is very low as compared to the prior art methods. By selecting and arranging the temperature, pressure, and kind of solvent, and controlling the starting material and the substrate on which the crystal is to grow, a single crystal with very few defects can be grown.

The following are Examples of the present invention.

**EXAMPLE 1**

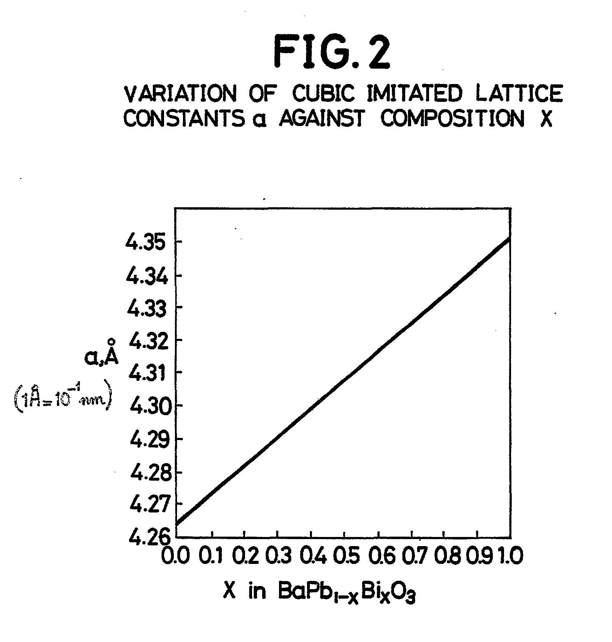

Commercially available high purity reagents $BaCo_3$, $PbO_2$, $Bi_2O_3$ were used as the starting material and adjustment of the amount thereof was effected so that the super-conductive composition factor x = 0.2, x = 0.3 within $BaPb_{1-x}Bi_xO_3$ respectively. After the adjustment, the starting material was blended in a mortar and baked for one whole day at 850°C in a stream of oxygen. To complete the reaction, the above process was repeated. When the resulting powder samples were examined using an X-ray diffractometer, they were observed to have $BaPb_{1-x}Bi_xO_3$ single phase. From measurements made the relation between lattice constant $\underline{a}$ (cubic imitated lattice constant) and composition factor $\underline{x}$ was as shown in Figure 2. Referring to Figure 2, the composition factors $\underline{x}$ corresponding to lattice constant $\underline{a}$ are respectively x = 0.21, x = 0.27.

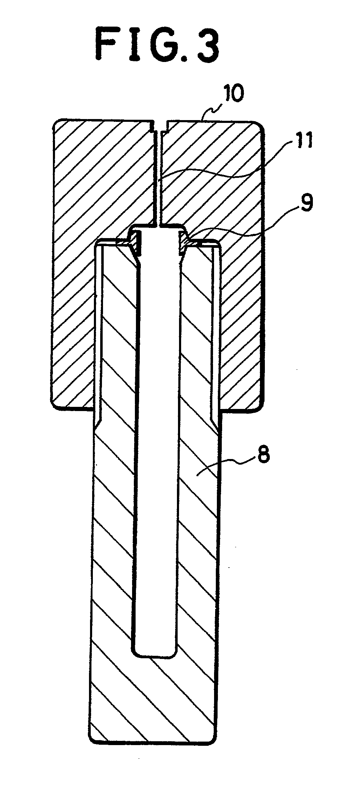

For a hydrothermal process, a test tube type autoclave 8 of stelite 25 was utilised. Figure 3 is a sectional diagram showing the structure of the autoclave. The autoclave 8 was pressure-sealed by a cover 10, through a sealing ring 9. The measurement of temperature within the autoclave was conducted through a temperature measuring hole 11. As a test tube a gold capsule of 3mm or 5mm diameter was utilised. A powder sample of $BaPb_{1-x}Bi_xO_3$ produced as above and a solvent were poured into the gold capsule, and the hydrothermal process was carried out. In this case distilled water filled the inside of the autoclave to maintain a pressure balance between the inner and outer surfaces of the gold capsule.

Three different solvents, namely 3 mol $NaNO_3$ aqueous solution, 3 mol $KNO_3$ aqueous solution, and 3 mol $LiNO_3$ aqueous solution were utilised, and the hydrothermal process was conducted for 7 days at a pressure of 1000kg/cm², and at a temperature of 410 to 450°C. The results are as shown in Table 1 where $\underline{o}$ indicates that crystallisation occurred.

## TABLE 1

| Sample No. | Density and the type of solvents | Whether the crystallisation occurs or not |
|---|---|---|
| 1 | 3 mol NaNO$_3$ aqueous solution | o |
| 2 | 3 mol KNO$_3$ aqueous solution | o |
| 3 | 3 mol LiNO$_3$ aqueous solution | o |

temperature 410 to 450°C
pressure 1000 kg/cm$^2$
growth period 7 days

It was observed that, with any of the above solvents, the samples were dissolved into and re-precipitated from the solution, and crystals were grown. The same result was obtained with the respective samples of composition factor x = 0.21, x = 0.27. When each of the resulting crystals was powdered and examined using an X-ray diffractometer, it was observed that all were of $BaPb_{1-x}Bi_xO_3$ single phase. The crystals with the best crystallisation characteristic and growth speed were obtained using $NaNO_3$ or $KNO_3$ aqueous solution as the solvent.

**EXAMPLE 2**

Example 1 was repeated utilising 3 mol $NaNO_3$ aqueous solution as the solvent, but at a temperature of 300 to 450°C. The results are shown in Table 2, where X indicates that crystallisation did not occur, and o indicates that crystallisation occurred.

## TABLE 2

| Sample No. | Temperature of the gold capsule | | Whether the crystallisation occurs or not |
|---|---|---|---|
| | Temperature upper part | of the lower part | |
| 4 | 320°C | 350°C | X |
| 5 | 360°C | 400°C | o |
| 6 | 410°C | 450°C | o |

solvent 3 mol $NaNO_3$ aqueous solution
pressure 1000 kg/cm$^2$
growth period 7 days

When the process temperature was 350°C, neither dissolution nor re-crystallisation was observed, and the sample remained in the lower part of the gold capsule. However, when the temperature was above 400°C, the sample was dissolved and re-crystallised, crystals with a diameter of about 2mm being grown. The same results were obtained with samples having composition factor x = 0.21 or x = 0.27. When the temperature was 450°C, even larger crystals were obtained but twin crystals were occasionally generated, the crystal surface being coarse with many secondary grains attached to it. These defects are thought to occur because secondary nucleation generates upon cooling. When the resulting crystals were powdered and examined using an X-ray diffractometer, it was observed that they were all $BaPb_{1-x}Bi_xO_3$ single phase. The composition factor $\underline{x}$ was determined and the same relation as shown in Figure 2 was found viz:

## TABLE 3

| Composition factor $\underline{x}$ of adjustment starting material | Composition factor $\underline{x}$ of the crystal after the hydrothermal synthesis |
|---|---|
| 0.21 | 0.20 |
| 0.27 | 0.25 |

$\underline{x}$ depends on $BaPb_{1-x}Bi_xO_3$.

Therefore, x = 0.21 changed to x = 0.20, and x = 0.27 changed to x = 0.25, but the composition gap between the adjusted starting material and the resulting crystal was minute for practical purposes.

Moreover, the relationship between composition factor $\underline{x}$ of starting material (nutrient) and composition factor $\underline{x}$ of resulting crystal were examined. When the composition factor $\underline{x}$ of starting material was equal to 0.1 or 0.3, the composition factor $\underline{x}$ of resulting crystal was 0.095 or 0.29 respectively. In the case of using a nitrate aqueous solution as the solvent single crystals of $BaPb_{1-x}Bi_xO_3$ with a desired composition factor $\underline{x}$ were easily manufactured with suitable adjustment to the starting material.

## EXAMPLE 3

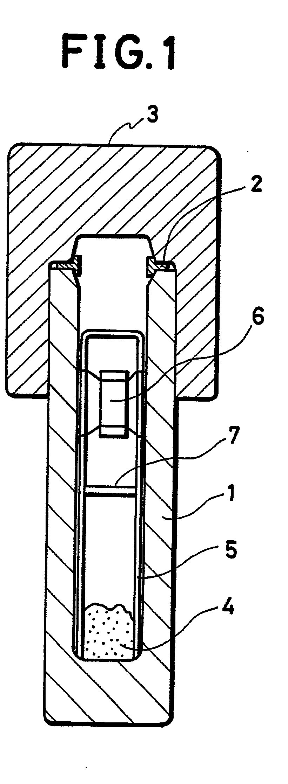

Figure 1 shows a test tube type autoclave 1 used in this Example. The autoclave 1 was of stelite 25 as in Example 1, but had a platinum plate inner lining to avoid contamination by impurities. The autoclave 1 was pressure-sealed with a cover 3, through a sealing ring 2. Nutrient 4 was provided at the bottom of the autoclave. This nutrient 4 was obtained by grinding and powdering polycrystalline $BaPb_{1-x}Bi_xO_3$ which was obtained in Example 2 and having a composition factor of either x = 0.20 or x = 0.25. Then a substrate 6 was mounted on an upper part of the autoclave above the nutrient 4, in a substrate support frame 5. The substrate 6 was a crystal of $SrTiO_3$ which has similar crystal structure and similar atom bond lengths to $BaPb_{1-x}Bi_xO_3$, the (001) crystal surface being used. Instead of the (001) surface, the (111) surface or the (110) surface could also be used. A buffer plate 7 was mounted on the substrate support frame 5 between the nutrient 4 and the substrate 6. 3 mol $NaNO_3$ aqueous solution as a solvent was charged in the autoclave in an amount such that a predetermined temperature and pressure could subsequently be obtained. A hydrothermal process under the same conditions as in Table 2 was initiated. These conditions were:

temperature of substrate 6 = 360°C
temperature of nutrient 4 = 400°C
pressure = 1000kg/cm²
growth period = 7 days.

After completion of the hydrothermal process, the autoclave was subjected to sudden cooling, to prevent the generation of secondary nucleation.

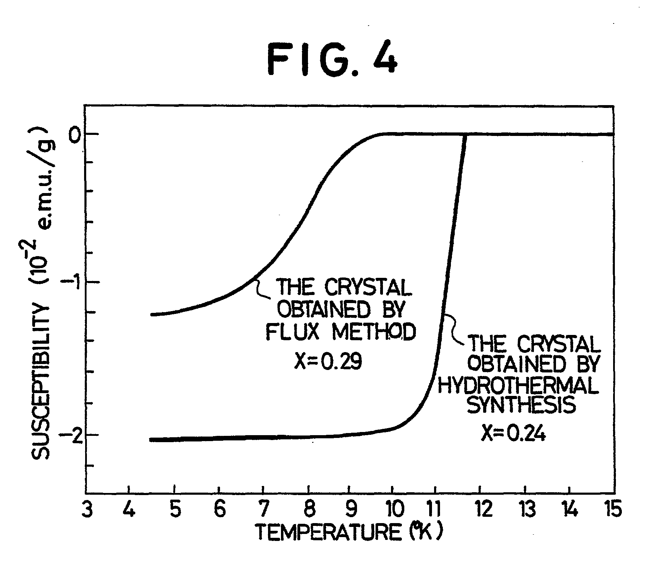

As a result, a thin film with a uniform thickness was formed on the substrate 6. When this film was examined using an X-ray diffractometer as in Example 1, it was identified to be a single crystal of $BaPb_{1-x}Bi_xO_3$. The composition factor $\underline{x}$ was found to be x = 0.20 or x = 0.24 respectively, no large change being observed as compared to the composition factor of the nutrient. When the super-conductive characteristics of the $BaPb_{1-x}Bi_xO_3$ thin film with the composition factor x = 0.24, was measured, it was confirmed that it showed super-conductivity when the super-conductive transition was at a range of 10.0°K to 11.7°K. The super-conducting characteristic is shown in Figure 4.

In the super-conducting characteristic curve of Figure 4, the temperature (°K) is plotted on the abscissa and the susceptibility ($10^{-2}$ e.m.u./g) as the super-conducting characteristic is plotted on the ordinate. From Figure 4, it will be appreciated that the crystal (x = 0.24) obtained by the hydrothermal process of Example 3 has greatly improved super-conducting characteristics over the crystal (x = 0.29) obtained by the conventional flux method.

**EXAMPLE 4**

Example 4 was similar to Example 3 but a different solvent was used. The conditions were as follows:
temperature of substrate 6 = 360°C
temperature of nutrient 4 = 400°C
solvent = aqueous solution which was 3 mol $NaNO_3$ aqueous solution to which 2% of the total weight of 2.0 mol $KClO_3$ aqueous solution was added
pressure = 1000kg/cm²
growth period = 7 days

As in Example 3, quenching was carried out after the hydrothermal process. In this Example, a thin film was also formed on the (001) surface of the $SrTiO_3$ substrate. This film was confirmed using an X-ray diffractometer to be a $BaPb_{1-x}Bi_xO_3$ thin film, and its super-conductivity similarly was observed at a range of 10.0°K to 11.7°K at the super-conductive transition temperature, but compared to Example 3 its superconductivity was clearer and better defined.

This is thought to be because a peroxide such as $NaClO_3$ was added to the solution, and this generated active oxygen. This generated oxygen prevented any oxygen deficiency inside the crystal, and atomic valence of the crystal was automatically controlled. Thus the mobility characteristic or super-conductive characteristic of the crystal was improved. Another advantage of using $NaClO_3$ is that after it has given up its oxygen it becomes NaCl in the aqueous solution. It thus has the advantage that it does not create impurities in the resulting crystals. $NaClO_3$ is not the only oxygen-generating compound that could be used: sodium perchlorate ($NaClO_4$) can be used in appropriate amounts.

As stated above, compared to the conventional KCl flux method or the crystallisation method from a non-stoichiometric solution, with the present invention there are several beneficial effects. For example, there is a very low level of potassium ion impurities in the crystals because the method according to the present invention utilises low viscosity nitrate aqueous solution at a relatively low temperature of 400 to 450°C. Also, as the appearance of super-conductivity of the single crystal of $BaPb_{1-x}Bi_xO_3$ is important, reproducibility of a given composition factor $x$ is very efficient. Consequently the present invention has a big industrial advantage in that single crystals with a desired composition factor $x$ are easily manufactured with suitable adjustment of the composition of the starting material. Similarly, as the method is carried out at a relatively low temperature of about 400°C defects such as strain or heat strain accompanying the phase transition is very small. Therefore, a more perfect crystal can be obtained, and at the same time, by adding oxygen-generating compounds such as peroxide compounds to the solvent the oxygen deficiency is reduced and the atomic valence is controlled. Consequently, it is possible to improve crystal perfection.

In accordance with the method according to the present invention, by obtaining a crystal with uniform composition factor $x$, improvement of super-conductivity is confirmed, and its effect is very large.

Also, because the temperature is approximately 400°C, it is very easy to conduct hydrothermal growth of single crystals of $BaPb_{1-x}Bi_xO_3$ on an industrial scale using existing equipment and apparatus.

As described above, in accordance with the present invention, single crystals of $BaPb_{1-x}Bi_xO_3$ valuable as super-conductive elements or optical electronic elements and having more perfect characteristics with little defects can be obtained.

**Claims**

1. A method of manufacturing asingle crystal of $BaPb_{1-x}Bi_xO_3$ by dissolving $BaPb_{1-x}Bi_xO_3$ in an aqueous solution and subjecting the resulting solution to a hydrothermal process at a temperature above 350°C, characterised in that the aqueous solution comprises a nitrate as the main component.

2. A method as claimed in claim 1, characterised in that said hydrothermal process is carried out in a pressure vessel and the single crystal of $BaPb_{1-x}Bi_xO_3$ is grown on an upper wall inside the pressure vessel.

3. A method of manufacturing a single crystal of $BaPb_{1-x}Bi_xO_3$ comprising: providing a starting material comprised of $BaCO_3$, $PbO_2$ and $Bi_2O_3$ mixed together; preparing a nutrient composed of polycrystalline $BaPb_{1-x}Bi_xO_3$ obtained from the starting material; and subjecting the nutrient in an aqueous solution to a hydrothermal process at a temperature above 350°C to effect growth of the single crystal of $BaPb_{1-x}Bi_xO_3$ characterised in that the aqueous solution includes a nitrate as the main component.

4. A method as claimed in claim 3 characterised in that said hydrothermal process is carried out in a pressure vessel, a temperature gradient being maintained between upper and lower portions of the pressure vessel.

5. A method of manufacturing a single crystal of $BaPb_{1-x}Bi_xO_3$ comprising: providing a nutrient composed of polycrystalline $BaPb_{1-x}Bi_xO_3$; and subjecting the nutrient in an aqueous solution to a hydrothermal process at a temperature above 350°C to establish a temperature gradient within the aqueous solution effective to promote the growth of the single crystal of $BaPb_{1-x}Bi_xO_3$ characterised in that the aqueous solution includes a nitrate as the main component.

6. A method as claimed in any preceding claim characterised in that said nitrate is any one or more of $LiNO_3$, $KNO_3$ and $NaNO_3$.

7. A method as claimed in any preceding claim characterised in that the single crystal of $BaPb_{1-x}Bi_xO_3$ is grown as a thin film on a substrate.

8. A method as claimed in claim 7 when dependent upon claim 7 characterised in that said substrate is maintained about 40°C lower than the nutrient.

9. A method as claimed in any preceding claim characterised by including quickly cooling the single crystal of $BaPb_{1-x}Bi_xO_3$ after the hydrothermal process.

10. A method as claimed in any preceding claim characterised in that the aqueous solution includes an oxygen-generating compound.

11. A method as claimed in claim 10 characterised in that the oxygen-generating compound is any one or more of $KClO_3$, $NaClO_3$ and $NaClO_4$.


**Patentansprüche**

1. Verfahren zur Herstellung eines Einkristalls aus $BaPb_{1-x}Bi_xO_3$ durch Lösen von $BaPb_{1-x}Bi_xO_3$ in einer wäßrigen Lösung und Behandlung der sich daraus ergebenden Lösung in einem hydrothermischen Prozeß bei einer Temperatur oberhalb von 350°C, dadurch gekennzeichnet, daß die wäßrige Lösung ein Nitrat als Hauptkomponente enthält.

2. Verfahren nach Anspruch 1, dadurch gekennzeichnet, daß der hydrothermische Prozeß in einem Druckgefäß durchgeführt wird und daß der Einkristall aus $BaPb_{1-x}Bi_xO_3$ auf einer oberen Wand innerhalb des Druckgefäßes aufgewachsen wird.

3. Verfahren zur Herstellung eines Einkristalls aus $BaPb_{1-x}Bi_xO_3$, bei dem ein Ausgangsmaterial aus einer Mischung von $BaCO_3$, $PbO_2$ und $Bi_2O_3$ hergestellt wird, aus polykristallinem $BaPb_{1-x}Bi_xO_3$, das aus dem Ausgangsmaterial erhalten wird, eine Nährsubstanz hergestellt wird und bei dem die Nährsubstanz in einer wäßrigen Lösung zur Realisierung des Aufwachsens des Einkristalls aus $BaPb_{1-x}Bi_xO_3$ einem hydrothermischen Prozeß bei einer Temperatur oberhalb 350°C unterworfen wird, dadurch gekennzeichnet, daß die wäßrige Lösung ein Nitrat als Hauptkomponente enthält.

4. Verfahren nach Anspruch 3, dadurch gekennzeichnet, daß der hydrothermische Prozeß in einem Druckgefäß durchgeführt wird und daß zwischen dem oberen und unteren Teil des Druckgefäßes ein Temperaturgradient aufrechterhalten wird.

5. Verfahren zur Herstellung eines Einkristalls aus $BaPb_{1-x}Bi_xO_3$, bei dem eine aus polykristallinem $BaPb_{1-x}Bi_xO_3$ zusammengesetzte Nährsubstanz hergestellt wird und die Nährsubstanz in einer wäßrigen Lösung einem hydrothermischen Prozeß bei einer Temperatur oberhalb 350°C unterworfen wird, um in der wäßrigen Lösung einen Temperaturgradienten zu realisieren, der das Wachstum des Einkristalls aus $BaPb_{1-x}Bi_xO_3$ fördert, dadurch gekennzeichnet, daß die wäßrige Lösung ein Nitrat als Hauptkomponente enthält.

6. Verfahren nach den vorhergehenden Ansprüchen, dadurch gekennzeichnet, daß als Nitrat eine oder mehrere der Verbindungen $LiNO_3$, $KNO_3$ und $NaNO_3$ Verwendung finden.

7. Verfahren nach den vorhergehenden Ansprüchen, dadurch gekennzeichnet, daß der Einkristall aus $BaPb_{1-x}Bi_xO_3$ als Dünnschicht auf einem Substrat aufgewachsen wird.

8. Verfahren nach Anspruch 7, dadurch gekennzeichnet, daß das Substrat auf einer Temperatur gehalten wird, die etwa um 40°C unter der Temperatur der Nährsubstanz liegt.

9. Verfahren nach den vorhergehenden Ansprüchen, dadurch gekennzeichnet, daß der Einkristall aus $BaPb_{1-x}Bi_xO_3$ nach dem hydrothermischen Prozeß schnell abgekühlt wird.

10. Verfahren nach den vorhergehenden Ansprüchen, dadurch gekennzeichnet, daß die wäßrige Lösung eine sauerstofferzeugende Verbindung enthält.

11. Verfahren nach Anspruch 10, dadurch gekennzeichnet, daß als sauerstofferzeugende Verbindung eine oder mehrere der Verbindungen $KClO_3$, $NaClO_3$ und $NaClO_4$ verwendet werden.


**Revendications**

1. Procédé de fabrication d'un monocristal de $BaPb_{1-x}Bi_xO_3$, qui consiste à dissoudre $BaPb_{1-x}Bi_xO_3$ dans une solution aqueuse, et à soumettre la solution obtenue à un processus hydrothermique à une température supérieure à 350°C, caractérisé en ce que la solution aqueuse comprend un nitrate comme constituant principal.

2. Procédé suivant la revendication 1, caractérisé en ce qu'il consiste à effectuer le processus hydrothermique dans un récipient sous pression et à faire croître le monocristal de $BaPb_{1-x}Bi_xO_3$ sur une paroi supérieure, à l'intérieure du récipient sous pression.

3. Procédé de fabrication d'un monocristal de $BaPb_{1-x}Bi_xO_3$, qui consiste à prévoir une matière de départ constituée de $BaCO_3$, de $PbO_2$ et de $Bi_2O_3$ mélangés ensemble; à préparer une substance-mère composée de $BaPb_{1-x}Bi_xO_3$ polycristallin obtenue à partir de la matière de départ; et à soumettre la substance-mère en solution aqueuse à un processus hydrothermique à une température supérieure à 350°C, pour effectuer la croissance du monocristal de $BaPb_{1-x}Bi_xO_3$, caractérisé en ce que la solution aqueuse comprend un nitrate comme constituant principal.

4. Procédé suivant la revendication, caractérisé en ce qu'il consiste à effectuer le processus hydrothermique dans un récipient sous pression, un gradient de pression étant maintenu entre des parties supérieure et inférieure du récipient sous pression.

5. Procédé de fabrication d'un monocristal de $BaPb_{1-x}Bi_xO_3$, qui consiste à prévoir une substance-mère composée de $BaPb_{1-x}Bi_xO_3$ polycristallin; et à soumettre la substance-mère en solution aqueuse à un processus hydrothermique à une température supérieure à 350°C, pour établir un gradient de température dans la solution aqueuse propre à favoriser la croissance du monocristal de $BaPb_{1-x}Bi_xO_3$, caractérisé en ce que la solution aqueuse comprend un nitrate comme constituant principal.

6. Procédé suivant l'une des revendications précédentes, caractérisé en ce que le nitrate est l'un quelconque ou plusieurs de $LiNO_3$, $KNO_3$ et $NaNO_3$.

7. Procédé suivant l'une quelconque des revendications précédentes, caractérisé en ce qu'il consiste à faire croître le monocristal de $BaPb_{1-x}Bi_xO_3$ sous la forme d'une mince pellicule sur un substrat.

8. Procédé suivant la revendication 7 attachée à la revendication 3, caractérisé en ce qu'il consiste à maintenir le substrat à une température inférieure de 40°C environ à celle de la substance-mère.

9. Procédé suivant l'une quelconque des revendications précédentes, caractérisé en ce qu'il consiste à refroidir rapidement le monocristal de $BaPb_{1-x}Bi_xO_3$, après le processus hydrothermique.

10. Procédé suivant l'une quelconque des revendications précédentes, caractérisé en ce que la solution aqueuse comprend un composé engendrant l'oxygène.

11. Procédé suivant la revendication 10, caractérisé en ce que le composé engendrant l'oxygène est l'un quelconque ou plusieurs de $KClO_3$, $NaClO_3$ et $NaClO_4$.

# FIG.1

# FIG. 2

## VARIATION OF CUBIC IMITATED LATTICE
## CONSTANTS a AGAINST COMPOSITION X

# FIG.3

# FIG. 4

Graph: SUSCEPTIBILITY ($10^{-2}$ e.m.u./g) versus TEMPERATURE (°K)

THE CRYSTAL OBTAINED BY FLUX METHOD X=0.29

THE CRYSTAL OBTAINED BY HYDROTHERMAL SYNTHESIS X=0.24